Europäisches Patentamt

European Patent Office

Office européen des brevets

(19)

(11) Veröffentlichungsnummer : **0 493 386 B1**

(12) **EUROPÄISCHE PATENTSCHRIFT**

(45) Veröffentlichungstag der Patentschrift :
**10.05.95 Patentblatt 95/19**

(51) Int. Cl.⁶ : $G01R\ 33/46$

(21) Anmeldenummer : **90910568.6**

(22) Anmeldetag : **23.07.90**

(86) Internationale Anmeldenummer :
**PCT/DE90/00556**

(87) Internationale Veröffentlichungsnummer :
**WO 92/01946 06.02.92 Gazette 92/04**

(54) **VERFAHREN UND VORRICHTUNG ZUR ERMITTLUNG VON CHEMISCHEN ZUSTÄNDEN VON LEBENDEM, TIERISCHEM ODER MENSCHLICHEM GEWEBE UNTER VERWENDUNG VON MAGNETISCHER RESONANZ.**

(43) Veröffentlichungstag der Anmeldung :
**08.07.92 Patentblatt 92/28**

(45) Bekanntmachung des Hinweises auf die
Patenterteilung :
**10.05.95 Patentblatt 95/19**

(84) Benannte Vertragsstaaten :
**CH DE FR GB LI NL**

(56) Entgegenhaltungen :
**EP-A- 0 125 651**
**US-A- 3 789 832**
**Electro Medica, Band 58, Nr. 1, März 1990, (Berlin, DE), H. König et al.: "Die quantitative Beurteilung von Veränderungen des hyalinen Gelenkknorpels unter Anwendung der FLASH-Sequenz", Seiten 14-22 siehe Seiten 14-16, Kapitel "Materialien und Methoden"; Seite 18, Zeile 59 - Seite 19, Zeile 66 Proceedings of the Eighth Annual Conference of the IEEE/Engineering in Medicine and Biology Society, Fort Worth, Texas, 7.-10. November 1986, Band 2, IEEE, M.B. Merickel et al.: "Multidimensional MRI pattern recognition of atherosclerosis", Seiten 1142-1145 siehe Seiten 1142, Kapitel "Abstract" and "Introduction"; Seiten 1143-1144, Kapitel "Results" und "Class Separability"**

(56) Entgegenhaltungen :
**Analytical Chemistry, Band 57, Nr. 11, November 1985, American Chemical Society, (Washington, US), P. Pfändler et al.: "Toward automated assignment of nuclear magnetic resonance spectra: Pattern recognition in two-dimensional correlation spectra", Seiten 2510-2516 siehe Seite 2510, Zeilen 1-32; Seiten 2511-2514, Kapitel "Basic Patterns" und "Outline of Procedure"**

(73) Patentinhaber : **Bruker Analytische Messtechnik GmbH**
**Silberstreifen**
**D-76287 Rheinstetten (DE)**

(72) Erfinder : **MOUNTFORD, Carolyn, E.**
**12 Bronhill Avenue**
**East Ryde, NSW 2113 (AU)**
Erfinder : **RUSSELL, Peter Royal Prince Alfred Hospital**
**Missenden Road**
**Camperdown, NSW 2006 (AU)**

(74) Vertreter : **Witte, Alexander, Dr.-Ing. et al**
**Witte, Weller, Gahlert & Otten**
**Patentanwälte**
**Rotebühlstrasse 121**
**D-70178 Stuttgart (DE)**

**Beschreibung**

Die Erfindung betrifft ein Verfahren zur Ermittlung von chemischen Zuständen von lebendem, tierischem oder menschlichem Gewebe unter Verwendung von magnetischer Resonanz mit einem homogenen Konstantmagnetfeld, wobei das Gewebe durch eine Magnetische-Resonanz-Messung ausgemessen wird und anschließend die erhaltenen Meßwerte durch Vergleich mit Meßwerten von Referenzmessungen von vergleichbarem Gewebe dahingehend ausgewertet werden, ob der chemische Zustand des Gewebes einem chemischen Normalzustand oder einem abweichenden abnormalen Endzustand entspricht.

Die Erfindung betrifft ferner eine Vorrichtung zur Ermittlung von chemischen Zuständen von lebendem, tierischem oder menschlichem Gewebe unter Verwendung von magnetischer Resonanz, mit einem hochauflösenden Magnetischen-Resonanz-Spektrometer zum Durchführen einer Magnetischen-Resonanz-Messung am Gewebe, mit Mittel zum Bestimmen von Meßwerten der Magnetischen-Resonanz-Messung am Gewebe, mit Mittel zum Speichern von Referenzwerten von Messungen an vergleichbarem Gewebe, und mit Mitteln zum Vergleichen der Meßwerte von aktueller Messung und Referenzmessung.

Ein derartiges Verfahren bzw. eine solche Vorrichtung ist aus der US-A-3 789 832 bekannt.

Bei dem bekannten Verfahren wird das Gewebe in ein homogenes Konstantmagnetfeld gegeben, und anschließend durch eine magnetische Resonanzmessung (Relaxationszeitmessung) ausgemessen. Das Gewebe kann dabei als Gewebeprobe in vitro gemessen werden, oder in vivo, wobei der gesamte menschliche oder tierische Körper in das homogene Konstantmagnetfeld eingebracht wird.

Bei der Messung wird die magnetische Resonanz der Protonen des gesamten Wassers im Gewebe gemessen. Dieses Verfahren beruht auf der Erkenntnis, daß sich der Grad der Assoziierung derjenigen Wassermoleküle, die mit Proteinketten in den Zellmembranen assoziiert sind, ausgehend von einem Normalzustand, der einem gesunden Zustand des Gewebes entspricht, in einen davon abweichenden abnormalen Endzustand ändern kann, wobei diese Änderung über eine Magnetische-Resonanz-Messung erfaßbar ist. Der abnormale Endzustand entspricht dem eines bösartigen (malignen) Tumors. Liegen nun Meßwerte von den entsprechenden Geweben in den beiden Zuständen, nämlich Normalzustand und abnormaler Endzustand vor, so kann aus einem Vergleich dieser Meßwerte mit den Meßwerten des aktuell gemessenen Gewebes eine Zuordnung getroffen werden, nämlich in welchem der beiden Zustände sich das Gewebe zum Zeitpunkt der Messung befunden hat.

Nachteilig an einem derartigen Verfahren und einer solchen Vorrichtung ist, daß lediglich eine Ja/Nein-Aussage gemacht werden kann, d.h., ob sich das Gewebe in dem einen oder dem anderen Zustand befindet. Die Aussage darüber, daß sich das Gewebe in dem abnormalen Endzustand mit groben morphologischen Veränderungen befindet, ist auch durch klassische histologische Methoden auf einfachere Art und Weise erbringbar und bringt keine Informationen über chemische Prozesse oder Zwischenzustände. Hat sich die Assoziation der Wassermoleküle mit den Proteinketten in den Zellmembranen derart verändert, daß dies durch die genannten Magnetische-Resonanz-Messungen erfaßbar ist, so liegt bereits ein weiterentwickelter Tumor vor, d.h. ein in andere Zellen eindringende Wucherung unter Bildung von Metastasen. In diesem fortgeschrittenen Zustand ist eine medizinische Behandlung des Gewebes nur schwer möglich und meist nicht erfolgreich. Es ist zwar aus den Messungen nach dem eingangs genannten Verfahren möglich, gewisse Aussagen über den Grad der Malignität zu machen, Voraussetzung dafür ist jedoch bereits das Vorhandensein eines malignen Tumors, d.h. die Aussage über das Vorhandensein des abnormalen Endzustandes ist allenfalls dahingehend differenzierbar, wie weit fortgeschritten dieser Zustand innerhalb der gemessenen Gewebeprobe ist.

Ferner ist nachteilig an dem eingangs genannten Verfahren, daß sich die Veränderung in dem Ausmaß der Assoziierung der Wassermoleküle mit den Proteinen der Zellmembrane manifestieren muß, d.h., daß die gemessene Veränderung erst als Folge eines Tumorwachstums zu detektieren ist. Andere chemische Veränderungen, die früher stattfinden oder selbst als Ursache für die spätere Entwicklung eines malignen Tumors in Frage kommen, werden nicht erfaßt.

Aus dem Dokument EP-A2-0 234 524 ist ein Verfahren bekannt, bei dem anhand magnetischer Resonanzmessungen von flüssigen Proben, z.B. Blutplasma, Serum oder dgl. Resonanzlinien in dem erhaltenen Spektrum ausgewählt werden, die anderen chemischen Substanzen als Wasser zugehörig sind, und die mit entsprechenden charakteristischen Linien von Referenzspektren verglichen werden, die dem abweichenden abnormalen chemischen Zustand entsprechen, in dem ebenfalls diese Substanzen vorhanden sind. Bei der Vergleichsmethode werden die Halbwertsbreiten (Linienbreite im Spektrum, auf halber Höhe einer Linie) herangezogen, wobei die ausgewählten Linien Protonen von verschiedenen Klassen der Lipoproteine zuzuordnen sind. Die daraus abgeleiteten "Fassel-Indices" sind zwar praktisch handhabbare Zahlenwerte, die jedoch nur eine Ja/Nein-Aussage bezüglich Normalzustand oder malignem Endzustand ermöglichen, und die allenfalls eine Differenzierung über den Grad der Malignität des erreichten Endzustandes ermöglichen. Lipoproteine können auch bei chemischen Veränderungen im Blut festgestellt werden, die nicht auf einen malignen Tumor

2

zurückzuführen sind. Ferner muß, damit ein maligner Endzustand eines Gewebes bestimmt werden kann, dieser schon sehr weit fortgeschritten sein, um aus dem Plasma verläßliche Aussagen zu treffen, die auch dadurch erschwert sind, daß in dem ausgewählten Frequenzbereich im Plasma andere atypische Frequenzen zu beobachten sind (siehe dazu G.N. Chmurny et al., "A NMR Blood Test for Cancer: a Critical Assessment", NMR in Biomedicine, Vol. 1, No. 3, 1988).

Durch hochauflösende Magnetische-Resonanz-Messungen können Proteolipide sowohl in eindimensionalen als auch zweidimensionalen (2D-COSY = two-dimensional scalar correlated spectroscopy) Spektren zur Ermittlung des chemischen Zustandes von Gewebe herangezogen werden. L. C. Wright et al., "A proteolipid in cancer cells is the origin of their high-resolution NMR spectrum", FEBS letters, Vol. 203, No. 2, S. 164-168 (1986).

Auch bei dem daraus bekannten Verfahren werden die Proteolipide im Plasma bestimmt, und lassen allenfalls den Rückschluß auf einen bedenklichen malignen Endzustand des Gewebes zu. Es ist zwar daraus bekannt geworden, daß durch hochauflösende Magnetische-Resonanz-Messungen gewisse, für den chemischen Endzustand charakteristische Substanzen möglicherweise bereits zu einem Zeitpunkt ermittelt werden können, zu dem klassische histologische Methoden dies noch nicht können, diese Verfahrensweise erlaubt jedoch ebenfalls nur die Aussage, daß dieser Endzustand, nämlich der maligne Zustand des Gewebes, bereits vorhanden ist.

Weitere Untersuchungen haben die zuvor erwähnten Kenntnisse untermauert, nämlich daß über hochauflösende Magnetische-Resonanz-Messungen die chemischen Endzustände von Gewebe, die malignen Zuständen entsprechen, möglicherweise zu einem wesentlich früheren Zeitpunkt erkannt werden können, als dies nach klassischen histologischen Methoden möglich ist (C. E. Mountford et al. "Classification of Human Tumours by High-Resolution Magnetic Resonance Spectroscopy", THE LANCET, Vol. 1, March 22, 1986, S. 651 - 653). Nachteilig auch an dieser Verfahrensweise ist, daß allenfalls der chemische Endzustand zu einem früheren Zeitpunkt erkannt werden kann, dieser aber ebenfalls bereits eingetreten sein muß.

Weitere Untersuchungen haben ergeben, daß Magnetische-Resonanz-Messungen zur Bestimmung des chemischen Zustandes von Gewebe auch andere Kerne als Protonen, nämlich z.B. Phosphor- oder Fluorkerne herangezogen werden können, wobei dies bei verschiedenartigen Geweben des menschlichen und tierischen Körpers möglich ist. (C.E. Mountford et al., "NMR Analysis of Cancer Cells" Progress in Clinical Biochemistry and Medicine, 1986, Vol. 3, S. 73-112).

Aus dem Dokument EP-A-0 125 651 ist ein Verfahren zum Erkennen von Krebszellen in vitro mittels der ESR-Spektroskopie bekannt geworden.

Nachteilig an allen zuvor erwähnten Verfahren und Vorrichtungen ist, daß sie lediglich eine Aussage darüber ermöglichen, ob ein gewisser chemischer Endzustand bereits vorhanden ist, wobei allenfalls dahingehend differenziert werden kann, wie weit dieser chemische Zustand bereits in dem Gewebe fortgeschritten ist.

Aufgabe der vorliegenden Erfindung ist daher, diese Nachteile zu überwinden und ein Verfahren und eine Vorrichtung zu schaffen, mittels derer die chemischen Übergangszustände zwischen einem chemischen Normalzustand und einem abweichenden abnormalen Endzustand ermittelt werden können.

Erfindungsgemäß wird die Aufgabe bei einem Verfahren der eingangs genannten Art dadurch gelöst, daß die erhaltenen Meßwerte mit einer solchen Reihe an Referenzmessungen verglichen werden, die auch die erfaßbaren charakteristischen Übergangszustände zwischen dem chemischen Normalzustand und dem abnormalen Endzustand enthalten, und daß aus dem Vergleich der chemische Übergangszustand der gemessenen Gewebeprobe bestimmt wird.

Erfindungsgemäß wird die Aufgabe bei einer Vorrichtung der eingangs genannten Art dadurch gelöst, daß die Mittel zum Speichern von Referenzwerten durch eine Datenbank gebildet werden, die eine solche Reihe an Referenzwerten von Referenzmessungen enthält, die auch die erfaßbaren charakteristischen Übergangszustände zwischen dem chemischen Normalzustand und dem chemisch abnormalen Endzustand umfassen, und daß eine Auswerteeinheit vorgesehen ist, die aus dem Vergleich der Meßwerte eine Zuordnung der aktuellen Messung zu einem chemischen Übergangszustand gibt.

Die erfindungsgemäße Aufgabe wird deswegen vollkommen gelöst, da durch den Vergleich mit Meßwerten von Übergangszuständen, die für den Endzustand selbst noch nicht charakteristisch sind, es möglich ist, den aktuellen chemischen Zustand des gemessenen Gewebes zwischen den beiden Grenzzuständen, nämlich Normalzustand (gesund) und abnormaler Endzustand (maligne), qualifiziert einzuordnen. Dies beruht auf der Kenntnis, daß bei der Umwandlung von einem chemischen Normalzustand in einen davon abweichenden abnormalen Endzustand charakteristische chemische Übergangszustände durchlaufen werden, die über Magnetische-Resonanz-Messungen erfaßbar sind. Intensive Nachforschungen haben ergeben, daß sich die Veränderung des Gewebes von einem chemisch normalen Zustand in einen davon abweichenden abnormalen Endzustand in mehrstufigen chemischen Prozessen abspielt, bei denen charakteristische Substanzen gebildet oder verbraucht werden, die über Magnetische-Resonanz-Messungen erfaßt werden können. Dazu ist es dann notwendig, eine Datenbank mit einer Reihe an Meßwerten von Referenzmessungen für diese Übergangszustände anzulegen, was beispielsweise dadurch geschehen kann, daß entsprechende Gewebeproben von verschiedenen tierischen oder menschlichen Individuen in verschiedenen chemischen Zuständen über Magnetische-Resonanz-Messungen ausgemessen werden und der entsprechende Datensatz in der Datenbank gespeichert wird. Die Meßwerte einer aktuellen Messung des Gewebes wird dann mit den charakteristischen Referenzwerten dieser Datenbank verglichen und daraus der aktuelle chemische Zustand des Gewebes bestimmt. Die charakteristischen Daten zur Bestimmung des Umwandlungszustandes einer Zelle ergeben sich durch das Speichern und Einordnen einer großen Anzahl an Messungen von entsprechendem Gewebe verschiedener Individuen in verschiedenen chemischen Zuständen, beispielsweise von verschiedenen Altersgruppen mit einer breiten Streuung. So haben zahlreiche und über längere Zeiträume durchgeführte Magnetische-Resonanz-Messungen deutlich aufgezeigt, daß z.B. gesundes menschliches Gewebe, wie das nachfolgend anhand der Ausführungsbeispiele näher erläutert wird, bei der Umwandlung in ein von Krebs befallenes Gewebe klar erfaßbare Zwischenzustände durchschreitet. Diese chemischen Zwischenzustände, die noch nicht zu dem Endzustand geführt haben, also beispielsweise zu einem bösartigen Karzinom, können durch beispielsweise chemische oder frühzeitige chirurgische Maßnahmen an der Weiterentwicklung in Richtung abnormalem Endzustand gehindert werden, so daß dieser für das Gewebe und letztendlich auch für den entsprechenden tierischen oder menschlichen Körper zerstörerische Endzustand nicht mehr erreicht wird. Das erfindungsgemäße Verfahren eröffnet daher eine Früherkennung und damit auch eine frühe Behandlungsmöglichkeit von krebsgefährdetem Gewebe.

Bei einer weiteren Ausgestaltung der Erfindung wird das Gewebe mittels einer hochauflösenden, insbesondere einer zweidimensionalen, beispielsweise einer 2D-COSY-Magnetischen-Resonanz-Messung ausgemessen und mit einer Reihe von entsprechenden Messungen von verschiedenen chemischen Übergangszuständen von entsprechendem Gewebe verglichen.

Diese Maßnahme hat den Vorteil, daß mittels der zweidimensionalen Kernresonanzspektroskopie eine zusätzliche Auftrennung der vielfältigen und im eindimensionalen Spektrum sonst überlappenden Resonanzsignale erzielt werden kann. So ist es beispielsweise möglich, chemisch sehr ähnliche $CH_3$-Gruppen anhand ihrer Kopplung mit benachbarten $CH_2$- oder CH- Gruppen zu identifizieren und daraus die jeweilige $CH_3$-Gruppe einer bestimmten Verbindung, beispielsweise einer Aminosäure im Gewebe zuzuordnen. Es wurde festgestellt, daß bei der Änderung des chemischen Zustandes der Zellen von menschlichem Gewebe verschiedene Metabolite, z.B. Aminosäuren produziert oder freigesetzt werden, die im Rahmen einer einzigen Messung über zweidimensionale Kernresonanzspektroskopie erfaßt werden können.

In einer weiteren Ausgestaltung der Erfindung wird als Kriterium des Vergleichs zwischen aktuellen Meßwerten des Gewebes und der Reihe an Referenzmeßwerten zumindest ein charakteristischer Cross-peak ausgewählt, und ermittelt, ob der zumindest eine Cross-peak vorhanden ist oder nicht.

Diese Maßnahme hat den Vorteil, daß durch einfach durchzuführende Vergleiche ein Übergangszustand ermittelt werden kann.

In einer weiteren Ausgestaltung der Erfindung wird bei der hochauflösenden zweidimensionalen Magnetischen-Resonanz-Messung des Gewebes ein oder mehrere Hochfrequenzimpulse, insbesondere der erste, die Transversalmagnetisierung erzeugende Hochfrequenzimpuls frequenzselektiv auf das Gewebe eingestrahlt, wobei die Bandbreite des Hochfrequenzimpulses zumindest die Resonanzfrequenz eines für einen chemischen Übergangszustand charakteristischen Moleküls umfaßt.

Diese Maßnahme hat den Vorteil, daß in der ersten Zeitdomäne (Anregunsphase) nur diejenigen Gruppen angeregt werden, beispielsweise CH-Gruppen, die bei Metaboliten, die für chemische Übergangszustände von Gewebe charakteristisch sind, auftreten, so daß in der zweiten Zeitdomäne (Detektionsphase) dann nur noch die Informationen über die Kopplungen dieser CH-Gruppen mit anderen Gruppen, z.B. $CH_3$-Gruppen des jeweiligen Metaboliten eingeholt werden, um eine eindeutige Identifizierung des jeweiligen Metaboliten sicherzustellen.

Dies hat den Vorteil, daß sehr rasch und gezielt diejenigen Messungen durchgeführt werden können, die die notwendige Information liefern, um einen gewissen chemischen Übergangszustand zu charakterisieren.

In einer weiteren Ausgestaltung der Erfindung werden, bei der Durchführung einer Magnetischen-Resonanz-Messung, nach Einstrahlung eines ersten, die Transversal-Magnetisierung erzeugenden Impulses so viele weitere, insbesondere 180°-Impulse vor dem zur Messung des freien Induktionszerfalls herangezogenen Impuls eingestrahlt, bis die Bedingung $m \cdot t_e$ größer $T_{2\,n\,i}$ für die nicht erwünschten Signale erfüllt ist, wobei m = der Anzahl der weiteren Impulse, $t_e$ die Spinechoevolutionszeit und $T_{2\,n\,i}$ die transversale Relaxationszeit nach dem zur Messung des freien Induktionszerfalls herangezogenen Impuls der nicht erwünschten Signale ist.

Durch diese Maßnahme wird ein $T_2$-gefiltertes Spektrum erhalten, bei dem die nicht aussagekräftigen Signale ausgefiltert sind, so daß lediglich die zu überprüfenden Signale erfaßt werden.

Diese Maßnahme hat den Vorteil, daß die Meßergebnisse anhand einfacher Spektren darzustellen sind, die dann entsprechend rasch und einfach sowohl visuell oder auch mittels rechnergesteuerter Anlagen ausgewertet werden können.

In einer weiteren Ausgestaltung der Erfindung werden die chemischen Übergangszustände des Gewebes zwischen Normal- und Endzustand in "unkritische", "bedenkliche" und "pre-maligne" Zustände unterteilt, wobei die entsprechenden Meßwerte der Referenzmessungen diesen Gruppen an Zuständen zugeordnet werden, so daß beim Vergleich der Meßwerte des gemessenen Gewebes zugleich eine Zuordnung zu einer Gruppe an vorgegebenen chemischen Übergangszuständen erfolgt.

Diese Maßnahme hat den Vorteil, daß die Ermittlung dahingehend vereinfacht ist, daß durch die rastermäßige Einteilung der verschiedenen chemischen Zustände besonders einfach erfaßbar der jeweilige Zustand zugeordnet werden kann. Dies eröffnet die Möglichkeit von Routineermittlungen mit dem erfindungsgemäßen Verfahren, die ohne weitere differenzierte Erklärungen oder Deutungen auch einem Laien aussagekräftig den jeweiligen chemischen Zustand des Gewebes vermitteln. Der Vergleich eines aktuellen gemessenen Spektrums mit gespeicherten Referenzspektren kann visuell, aber auch vorzugsweise automatisch geschehen, etwa über ein Programm zur automatischen Spektrenerkennung. Bei der automatischen Meßwerterfassung und -auswertung muß nicht ein komplettes 2D-Spektrum erstellt werden, sondern es genügt unter Umständen, gezielt nur die relevanten Cross-peaks zu vermessen und mit vorgegebenen Schwellwerten zu vergleichen. Diese Einschränkung spart Meßzeit oder erlaubt bei gleicher Meßzeit im interessierenden Bereich eine höhere Auflösung.

In einer weiteren Ausgestaltung der Erfindung wird der Reihe an Referenzmessungen solche Werte hinzugefügt, die chemischen Zwischenzuständen des Gewebes entsprechen, die aus chemischen Veränderungen stammen, die nicht unmittelbar in direkten chemischen Umwandlungsprozeß zwischen normalen und abnormalen Endzustand beteiligt sind, wobei diese Veränderungen jedoch zu dem zum abnormalen chemischen Endzustand führenden Umwandlungsprozeß führen können.

Diese Maßnahme hat den Vorteil, daß auch solche chemische Umwandlungsprozesse bei dem Ermittlungsverfahren einbezogen werden, die aus anderen chemischen Umwandlungsprozessen stammen, die aber im Laufe ihrer Umwandlung ein Stadium erreichen, das ebenfalls zu dem chemisch abnormalen Endzustand des Gewebes führen können. In praktischer Hinsicht hat dies dahingehend Bedeutung, daß ein Gewebe sich aufgrund verschiedenartiger Auslöseereignisse in den Umwandlungsprozeß auf den chemisch abnormalen Endzustand begeben kann. So kann beispielsweise eine das Gewebe befallende Krankheit dieses chemisch verändern, ohne daß dadurch ein solcher chemischer Prozeß ausgelöst wird, der zu dem chemisch abnormalen Endzustand führt. Es ist jedoch möglich, daß in einem von einer solchen Krankheit einmal befallen Gewebe latent eine Auslösesubstanz vorhanden ist, die zu einem viel späteren Zeitpunkt doch noch einen Umwandlungsprozeß in den chemisch abnormalen Endzustand auslösen kann. Wird also die latent vorhandene Auslösesubstanz über eine Magnetische-Resonanz-Messung erfaßt, so kann diese gespeichert werden und bei weiteren Ermittlungen dann berücksichtigt werden. So wurde beispielsweise festgestellt, daß bei Frauen, deren Gewebe des Muttermundes mit Papillomaviren befallen war, einem erhöhten Krebsrisiko des Muttermundes ausgesetzt sind. Gewebe, das mit dem Papillomavirus befallen ist, weist über Magnetische-Resonanz-Messung erfaßbare Substanzen auf, die dann in den Meßwertsatz der Referenzmessungen aufgenommen werden können. Es ist also nicht nur möglich, den mit Papillomavirus befallenen Ist-Zustand festzustellen, sondern auch gleichzeitig die latente Gefahr für die Entwicklung zu einem bösartigen Krebs rechtzeitig zu dokumentieren und bei späteren Messungen zu berücksichtigen.

In einer weiteren Ausgestaltung der Erfindung wird eine durch Biopsie erhaltene Gewebeprobe oder durch Kultivierung erhaltene Zellmasse in vitro der Magnetischen-Resonanz-Messung unterzogen.

Im Sinne der vorliegenden Erfindung sind unter dem Begriff "Gewebe" auch derartige Zellmassen zu verstehen.

Diese Maßnahme hat den Vorteil, daß das Verfahren mit einfachen apparativem Aufwand durchgeführt werden kann, und daß die Gewebeprobe durch geeignete Zusätze meßtechnisch aufbereitet werden kann.

Es ist auch möglich, in vivo Kernresonanzspektren volumenselektiv d.h. nur für einen bestimmten, räumlich definierten Bereich einer Probe aufzunehmen. Mit dieser Aufnahmetechnik ist es nämlich möglich, beispielsweise an einem lebenden Körper ein Kernresonanzspektrum eines bestimmten definierten Punktes in einem inneren Organ des Körpers aufzunehmen. Die Aufnahme von volumenselektiven Kernresonanzspektren ist eine an sich bekannte Technik, Beispiele finden sich im Lehrbuch von Wehrli, Derek Shaw und J. Bruce Kneeland "Biomedical Magnetic Resonance Imaging", Verlag Chemie, 1988, Seiten 1 bis 45 und 521 bis 545.

In einer weiteren Ausgestaltung der Erfindung wird auf solche Cross-peaks in einem 2D-COSY-Protonen-Spektrum ausgewertet, die den für den Umwandlungsprozeß charakteristischen Metaboliten, insbesondere die für den Aufbau von menschlichem Eiweiß notwendigen Aminosäuren entsprechen. Dabei wird insbesondere eine Gewebsprobe des Gebärmutterhalses (Cervix uteri) herangezogen, und bei Vorhandensein von Cross-peaks von zumindest einer der Aminosäuren Isoleucin (Ile), Leucin (Leu), Valin (Val) und/oder Phenylalanin (Phe) in der Gewebeprobe, wird der chemische Zustand als "pre maligne" gewertet.

Diese Maßnahmen haben den Vorteil, daß über bestimmte Parameter bestimmte chemische Zustände erfaßt werden können, z.B. ein solcher, der für das Gewebe noch nicht bedenklich ist, jedoch in hohem Maße geeignet ist, in den kritischen abnormalen chemischen Zustand überzugehen. In der praktischen Anwendung hat dies den Vorteil, daß Tumore, die sich noch nicht zu einem histologisch erkennbaren malignen Karzinom entwickelt haben, klar von diesem unterscheidbar erkannt und klassifiziert werden können, wobei ein Tumor in der "pre-malignen" Phase noch durch operative oder chemische Behandlungen entfernt werden kann, ohne daß das verbleibende Gewebe ernsthaft beeinträchtigt wird, und vor allem, bevor ein Metastasen verursachender maligner Zustand erreicht wird.

In einer weiteren Ausgestaltung wird bei der Ermittlung des chemischen Zustandes auf diejenigen Cross-peaks ausgewertet, die, neben den für den "pre-malignen" Zustand charakteristischen Signalen, Laktat zuordenbar sind, und wobei ein solcher chemischer Zustand als "maligner Endzustand" klassifiziert wird.

Diese Maßnahme hat den Vorteil, daß eine relative scharfe Abgrenzung zwischen dem "pre-malignen" und dem "malignen Endzustand" geschaffen ist, somit eine klare Unterscheidung des chemischen Zustandes im Bereich des kritischen Überganges zwischen "pre-maligne" und "maligne" möglich ist.

In einer weiteren Ausgestaltung der Erfindung wird eine Protonen-Magnetische-Resonanz-Messung durchgeführt, bei der das Wassersignal durch Vorsättigung unterdrückt wird.

Diese Maßnahme hat den Vorteil, daß das intensive Signal des gegenüber den charakteristischen Substanzen in hohem Überschuß vorhandenen Wassers unterdrückt wird, so daß dann störungsfrei auch interessierende Signale von Metaboliten in niedriger Konzentration ermittelt werden können.

Diese Maßnahme hat auch den Vorteil, daß beispielsweise die gesamte, einem Gewebe entnommene Probe in wässrigem Medium ausgemessen werden kann, so daß, auch sehr geringe Mengen an charakteristischen Substanzen, die auch nur in wenigen Zellen vorhanden sind, bereits erkannt werden können. Es besteht also nicht die Gefahr, wie bei klassischen histologischen Gewebeprobeuntersuchungen, daß möglicherweise in dem tatsächlich zur Untersuchung herangezogenen Schnitt nicht diejenigen Gewebeteile vorhanden sind, die den veränderten chemischen Zustand beinhalten.

Weitere Vorteile ergeben sich aus der Beschreibung und den beigefügten Zeichnungen. Ausführungsbeispiele der Erfindung sind in der Zeichnung dargestellt und werden in der nachfolgenden Beschreibung näher erläutert. Es zeigen:

Fig. 1      eine schematische Darstellung von verschiedenen chemischen Zuständen von menschlichem Gewebe;

Fig. 2      ein 400 MHz Protonen-2D-COSY-Spektrum einer durch Biopsie gewonnenen Gewebeprobe eines weiblichen Gebärmutterhalses in einem Phosphatpuffer/$D_2$O-Gemisch, das sich in einem chemischen Normalzustand befindet;

Fig. 3      ein Diagramm zur Erläuterung der Impulsfolge, wie sie bei der Aufnahme des in Fig. 2 dargestellten Spektrums verwendet wurde;

Fig. 4      ein Diagramm einer Impulsfolge mit $T_2$-Filterung;

Fig. 5      eine dem Spektrum von Fig. 2 entsprechendes Spektrum einer Gewebeprobe eines Gebärmutterhalses in fortgeschrittenem, invasiven Krebszustand;

Fig. 6 bis 11      2D-COSY-Spektren entsprechend dem Spektrum von Fig. 2, wobei verschiedene aufeinanderfolgende chemische Übergangszustände von Gewebeproben zwischen dem in Fig. 2 gezeigten gesunden Zustand und dem in Fig. 5 gezeigten Zustand dargestellt sind, wobei in der rechten unteren Dreieckshälfte der Darstellung jeweils die in diesem Übergangszustand zusätzlich auftauchenden Cross-peaks aufgezeigt sind, und

Fig. 12      stark schematisiert eine erfindungsgemäße Vorrichtung.

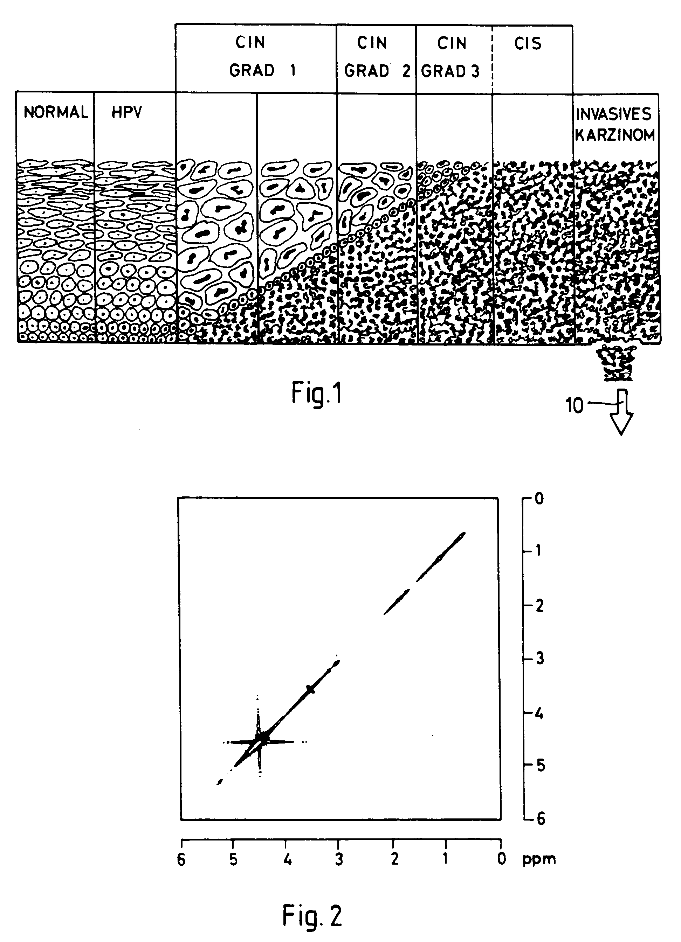

In Fig. 1 sind stark schematisiert verschiedene Entwicklungszustände von Gewebe im Bereich des Gebärmutterhalses (Cervix uteri) einer weiblichen Person dargestellt. Dabei entspricht das auf der linken Seite dargestellte Gewebe einem NORMAL-Zustand mit regelrechtem Zellbild. Daran schließt sich ein Zellbild an, wie es sich bei einer Infektion mit Papillomaviren (Human Papilloma Virus) ergibt. Dabei haben am Gewebe selbst keine erkennbaren Veränderungen stattgefunden. Es können ebenfalls bläschenartige Vakuolen beobachtet werden. An das mit HPV bezeichnete Gewebebild schließt sich ein mit CIN (Cervical Intraepithelial Neoplasmia) bezeichneter Entwicklungszustand mit einer intraepithelialen Neoplasie der Cervix an. Dabei werden zwei Bereiche des Grades 1 unterscheiden, nämlich solche mit sehr leichter und leichter ephitelialer Dysplasie. In den mit Grad 1 bezeichneten Entwicklungszuständen finden mehr oder minder ausgeprägte metaplastische, degenerative bzw. regenerative Veränderungen des Gewebes statt. In dem mit Grad 2 bezeichneten Entwicklungszustand der mittelgradigen Dysplasie haben bereits schwere degenerative Veränderungen der Zellen stattgefunden bzw. es ist bereits eine große Anzahl regressiv veränderter Zellen vorhanden.

An diesem Bereich schließt sich ein mit Grad 3 bezeichneter Bereich der schweren Dysplasie an, die bereits als Vorstufe zu einem Karzinom anzusehen ist. Dieser Zustand wird im Sinne der vorliegenden Anmeldung schon als "pre-maligne" betrachtet. In diesem Zustand ist durch die klassischen histologischen Methoden das Gewebe noch nicht als Karzinom zu erkennen bzw. zu klassifizieren. In diesem Zustand kann sich das Gewebe wieder in einen Normalzustand zurückentwickeln, wobei die Regressionsrate nur etwa bei 20 % liegt, wohingegen die Regressionsrate bei mittlerer Dysplasie noch immerhin 50 % beträgt.

In den mit CIS (Carzinoma In Situ) bezeichneten Entwicklungszustand hat sich ein Karzinom gebildet, das noch nicht invasiv ist, d.h. es findet noch keine Wucherung in andersartigem Gewebe statt, d.h. es haben sich noch keine Metastasen gebildet.

Das Gewebe hat seinen chemisch abweichenden Endzustand dann vollständig erreicht, falls es im wesentlichen aus malignen Tumorzellen aufgebaut ist, die invasiv sind, wie dies in Fig. 1 durch einen Pfeil 10 angedeutet ist.

Untersuchungen haben gezeigt, daß Gebärmutterhalsgewebe, das sich im Zustand Grad 1 (leichte bis mittlere Dysplasie) befindet, mit einer mittleren Umwandlungszeit von 6 Jahren in Grad 2 Gewebe umwandelt. Die mittlere Umwandlungsdauer von Grad 2 in Grad 3 beträgt etwa 3 Jahre. Der Umwandlungszeitraum von Grad 3 in CIS beträgt etwa 1 Jahr.

Ferner wurde beobachtet, daß in einem Zeitraum von 10 Jahren etwa 70 % an in CIS eingestuftes Gewebe sich in ein invasives Karzinom fortentwickelt.

Erfolgsversprechende Behandlungsmethoden stehen bis zum Zustand CIS zur Verfügung, wobei in der Übergangsphase von Grad 1 zu Grad 3 noch chemische Behandlungsmethoden möglich sind, ohne daß ein chirurgischer Eingriff notwendig ist.

Die Übergänge von dem in Fig. 1 auf der linken Seite dargestellten NORMAL-Zustand, der einem chemischen Normalzustand des Gewebes entspricht, zum auf der rechten Seite dargestellten invasiven Karziom, das einem abnormalen chemischen Endzustand des Gewebes entspricht, können anhand der nachfolgend aufgezeigten 2D-COSY-Spektren ermittelt werden.

Zur Durchführung der Messungen, die zu den in Fig. 2, 5 bis 11 dargestellten 2D-COSY-Spektren führen, wird jeweils eine Gewebeprobe (1 x 2 x 3 mm) vom Gebärmutterhals von weiblichen Probanden entnommen. Die Proben werden in einen isotonen Kochsalz-Phosphatpuffer (PBS) in $D_2O$ gegeben, in flüssigem Stickstoff schockgefroren und dann bei -70°C aufbewahrt. Zum Durchführen der Messung wird die Gewebsprobe nach Auftauen erneut mit PBS/$D_2O$ gewaschen und auf einen Glaswollstopfen in einem 5-mm-Meßröhrchen gelegt. Anschließend wird die Probe mit einem PBS/$D_2O$-Gemisch überschichtet. Die 2D-COSY-Messungen wurden bei 37°C mit einem Bruker WM-400 Spektrometer (9,4 Tesla) durchgeführt, der mit einem Aspect-2000-Computer (Bruker/Sepktrospin, Fallenden) ausgestattet ist. Als externer Standard wurde Natrium-3-(trimethylsilyl)-propylsulfonat verwendet.

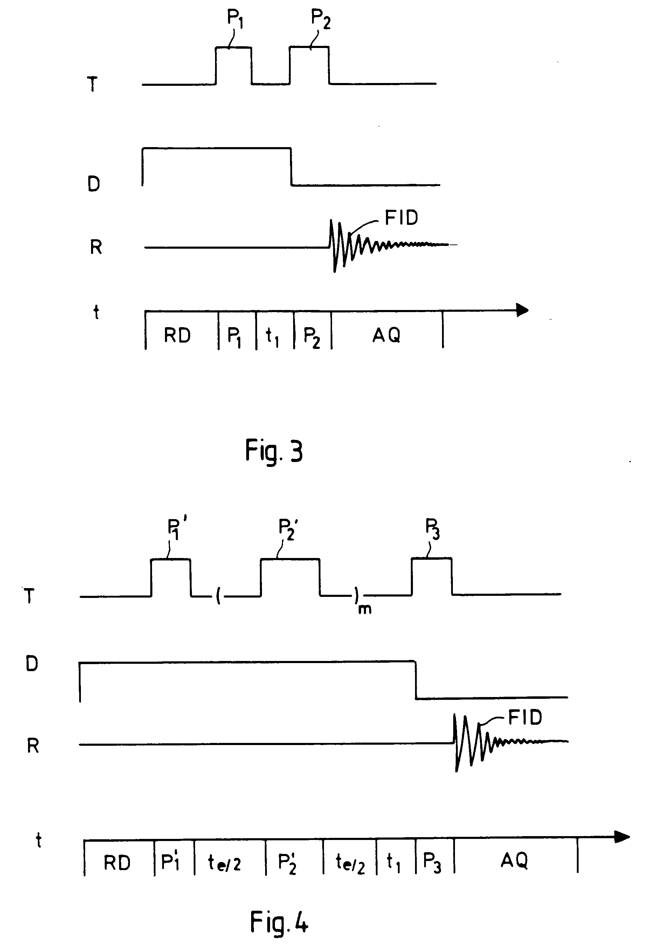

Die Impulsfolge ist in Fig. 3 schematisch dargestellt.

Der Decoupler D sorgt für eine Vorsättigung des $H_2O$-Signales. Die Relaxationsverzögerungszeit RD liegt etwa im Bereich von einer Sekunde. Danach wird ein 90°-Hochfrequenzimpuls $P_1$ (6,3 $\mu$s) eingestrahlt.

Nach einer Evolutionszeit $t_1$, nach der der Decoupler kein Sättigungssignal mehr aussendet, wird ein weiterer 90°-Hochfrequenzimpuls $P_2$ vom Sender T ausgesandt und anschließend während der Aquisitionszeit AQ der freie Induktionszerfall FID durch den Empfänger R gemessen.

Die Evolutionszeit $t_1$ wird in Zeitschritten $t_{in}$ inkrementiert, wobei $t_1$ von $t_{1min}$ bis $t_{1max}$ läuft, $t_{in}$ durch die gewünschte Spektralbreite SW vorgegeben ist, und folgendes gilt:

$$t_{1max} = t_{1min} + (TD1 - 1) t_{in}$$

Zur Verbesserung des Signal-zu-Rausch-Verhältnisses wird für jeden relativen Zeitpunkt $t_1$ die Messung n-mal wiederholt und akkumuliert.

Weitere typische Paramter sind AQ = 0,356 Sekunden, RD = 1 Sekunde, $P_1 = P_2 = 6,3$ $\mu$s, $t_{1min} = 5$ $\mu$s, $t_{in}$ = 348 $\mu$s und TD1 = 200, n = 32, SW = 2874 Hz, TD2 = 2048.

Nach der Messung wird eine TD1 x TD2 Datenmatrix in der Zeitdomäne erhalten, die über eine 2D-Fourier-Transformation eine entsprechende Matrix in der Frequenzdomäne ergibt.

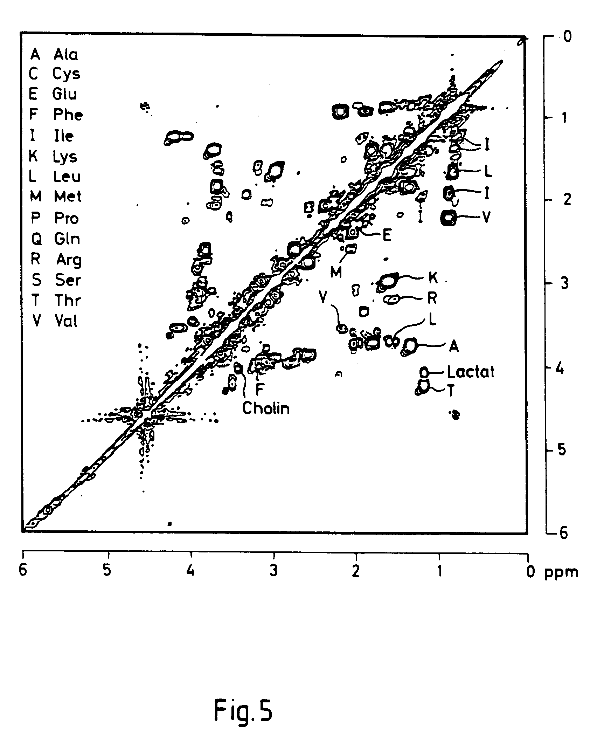

Wie bereits erwähnt, können diese und die nachfolgend beschriebenen Messungen so eingeschränkt werden, daß sie im wesentlichen die interessierenden Ausschnitte (Umgebung der Cross-peaks) der in Fig. 5 bis 11 dargestellten Spektren liefern. Diese können dann in kürzerer Zeit erhalten werden, oder, bei gleicher Meßzeit, mit besserer Auflösung.

In Fig. 2 ist ein Contour Plot des zweidimensionalen COSY-NMR-Spektrums der in Fig. 1 mit "NORMAL" bezeichneten Gewebeprobe dargestellt. Die in der Diagonale vorhandenen Höhenlinien zeigen ein Höhenlinienintensitätsprofil, das einem eindimensionalen Spektrum entspricht. Die chemischen Verschiebungen in ppm gegenüber dem Standard in der unteren waagerechten Skala sind wie in einem eindimensionalem NMR zu betrachten. Wie aus Fig. 2 zu entnehmen, treten beidseits der Diagonale, abgesehen vom sternförmigen Gebilde des Restwassersignals bei 4,7 ppm keine Cross-peaks auf.

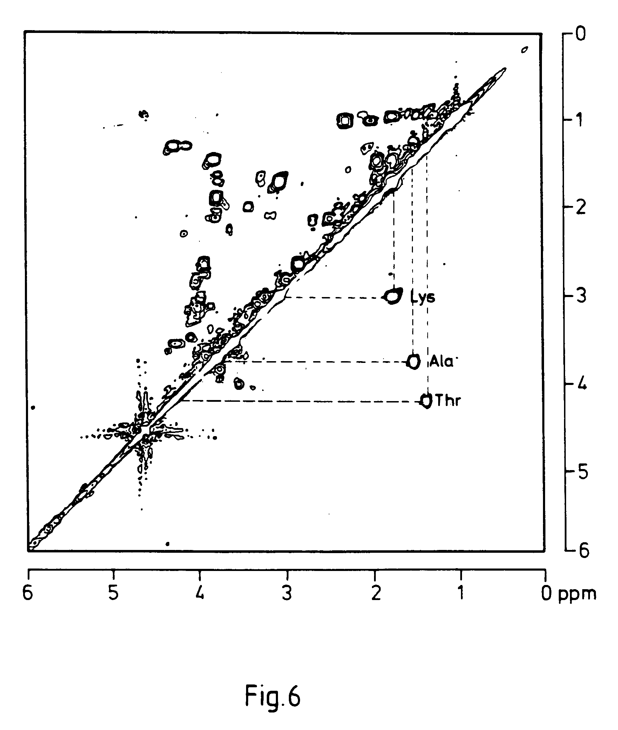

Das in Fig. 5 dargestellte 2D-COSY-Spektrum ergab sich durch Messen einer Gebärmutterhalsgewebeprobe eines invasiven Karzinoms, wie es also in Fig. 1 auf der rechten Seite dargestellt ist. Aus dem Vergleich zwischen Fig. 2 und 5 ist zu entnehmen, daß zahlreiche Cross-peaks paarweise symmetrisch zur Diagonalen festzustellen sind. Deren Zuordnung zu den einzelnen Übergangszuständen zwischen dem in Fig. 2 und dem in Fig. 5 gezeigten Zuständen erfolgt anhand der in Fig. 6 bis 11 dargestellten Spektren.

Bei den in Fig. 6 bis 11 dargestellten Spektren entspricht die obere linke Dreieckshälfte dem oberen linken Dreieck der Darstellung in Fig. 5, also dem Spektrum des invasiven karzinösen Gewebes. In der Reihenfolge der Spektren in Fig. 6 bis 11 sind im rechten unteren Dreieck jeweils nur diejenigen zusätzlichen Cross-peaks aufgezeichnet, die gegenüber einem vorher aufgezeigten Zustand zusätzlich auftreten, ohne daß die vorher aufgetretenen Cross-peaks nochmals aufgeführt sind.

Das in Fig. 6 gezeigte Spektrum entspricht dem in Fig. 1 mit HPV gekennzeichneten Zustand des Gewebes, d.h. das Gewebe war mit einem Papillomavirus infiziert.

Für diesen Zustand tauchen im Spektrum charakteristische Crosspeaks für die Aminosäuren Lysin (Lys, K), Alanin (Ala, A) und Threonin (Thr, T) auf.

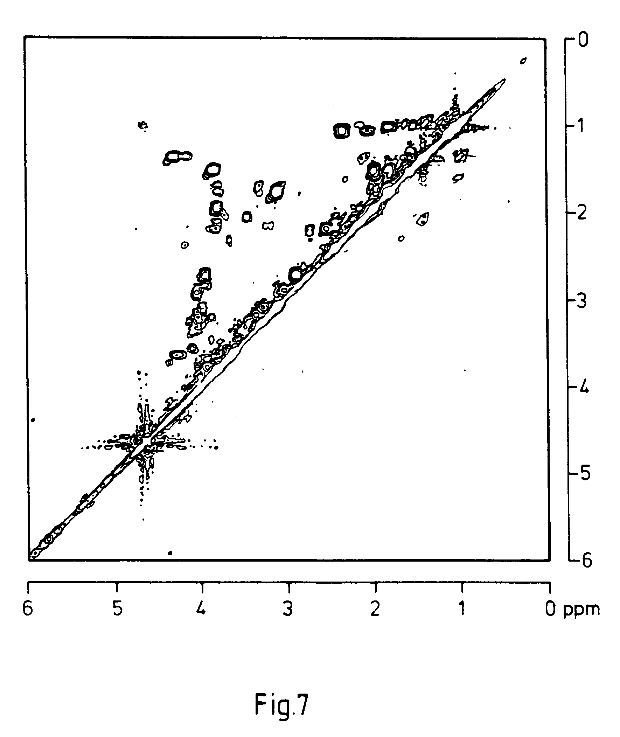

Das in Fig. 7 dargestellte Spektrum entspricht dem in Fig. 1 mit Grad 1 bezifferten Zustand mit leichter Dysplasie. In diesem Zustand finden bereits Veränderungen in den Zellmembranen statt, wobei dies sich in Cross-peaks manifestiert, die im Bereich von etwa 0,8 und 1,3 ppm (waagerechte Skala) erscheinen. Diese Cross-peaks können Lipidstrukturen zugeordnet werden.

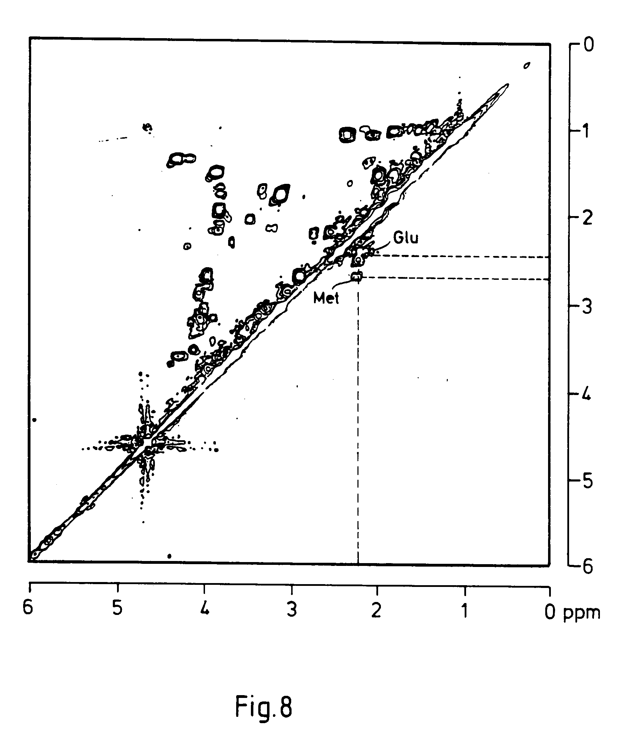

Das in Fig. 8 dargestellte Spektrum entspricht einem in Fig. 1 mit Grad 2 bezeichneten Zustand mit fortschreitender Dysplasie. In diesem Veränderungszustand nehmen die durch die HPV-Infektion vorhandenen Vakuolen und die HPV zugeordneten Cross-peaks ab. Es treten die charakteristischen Cross-peaks für Methionin (Met, M, 2,2 ppm - 2,6 ppm) und Glutaminsäure (Glu, E, 2,2 ppm - 2,4 ppm) auf.

Die in Fig. 6 und 7 neu aufgetauchten Cross-peaks können in einer Gruppe an "unkritischen" Cross-peaks zusammengefaßt werden, die in Fig. 8 neu auftauchenden Cross-peaks der Gruppe "bedenklich". Die Daten (z.B. chemische Verschiebung, Intensität) dieser Cross-peaks werden in einer Datenverarbeitungsanlage gespeichert.

Wird eine Gewebsprobe einer weiblichen Probandin entsprechend der zuvor beschriebenen Weise entnommen und einer 2D-COSY-Messung wie zuvor beschrieben unterzogen, und werden die ermittelten Daten (z.B. chemische Verschiebung, Intensität) mit den gespeicherten verglichen, so lassen die in Fig. 6 aufgezeigten Cross-peaks der Aminosäuren Lysin, Threonin und Alanin den Rückschluß auf eine HPV-Infektion zu. Diese Tatsache allein ist Anlaß, in Zeitabständen von etwa 1 bis 2 Jahren entsprechende Untersuchungen nachfolgen zu lassen, um festzustellen, ob nach der HPV-Infektion sich Cross-peaks zeigen, wie sie in Fig. 7 und 8 dargestellt sind. Werden solche Crosspeaks ermittelt, kann daraus dann auf eine sich entwickelnde Dysplasie geschlossen werden.

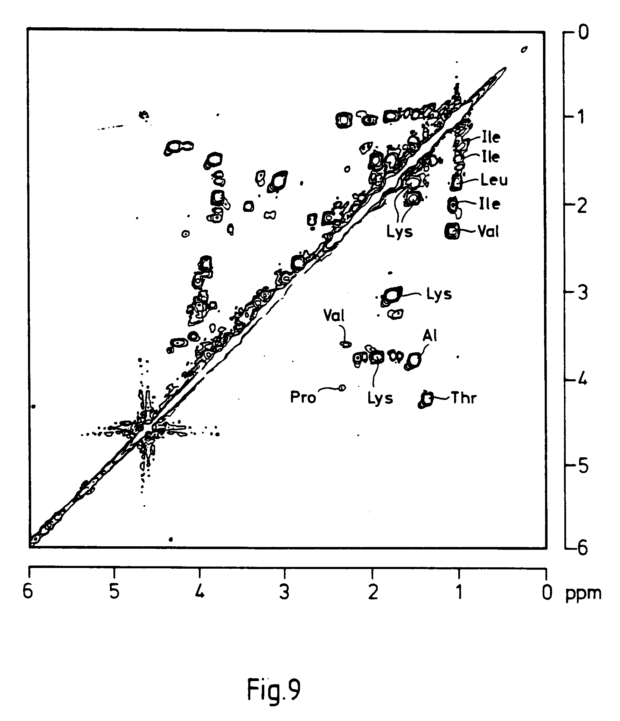

In Fig. 9 ist ein 2D-COSY-Spektrum einer Gewebsprobe dargestellt, wie sie in Fig. 1 in die Kategorie Grad 3 eingestuft ist. In diesem "pre-malignen" Zustand treten verstärkt Crosspeaks von Aminosäuren auf, insbesondere von Isoleucin (Ile, I), Leucin (Leu, L) Valin (Val, V) Threonin (Thr, T) Alanin (Ala, A), Prolin (Pro, P) und Lysin (Lys, K).

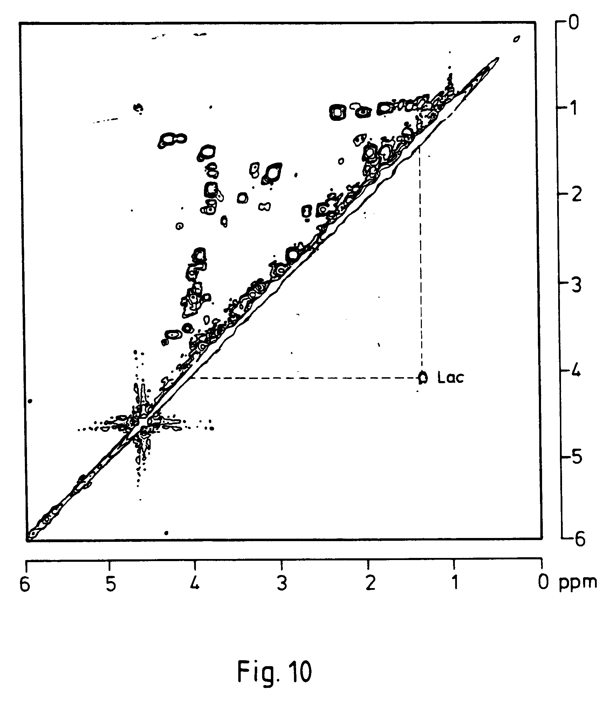

Dieser Zustand, wie er in Fig. 9 gezeigt ist, ist klar unterscheidbar von dem in Fig. 10 dargestellten Zustand, der einen zusätzlichen Cross-peak bei 1,4 ppm - 4,1 ppm aufweist, der Lactat zuzuordnen ist. Der Lactat Crosspeak tritt erstmals in einem sehr frühen Zustand eines invasiven Karzinomes auf, er wurde jedoch nie in dem in Fig. 9 entsprechenden Zustand aufgefunden.

Somit ist der Cross-peak des Lactats ein mögliches deutliches Unterscheidungsmerkmal zum Abgrenzen des in Fig. 9 noch als "pre-malignes" Stadium zu bezeichnenden Zustandes von dem "frühen invasiven" Zustand von Fig. 10. Ein Gewebszustand, wie er durch das in Fig. 9 dargestellte Spektrum repräsentiert wird, ist bei einer histologischen Untersuchung noch nicht als Karzinom zu erkennen, so daß dieses Stadium durchaus nach histologischen Methoden noch in beispielsweise "Grad 2"-Stufen einklassifiziert werden könnte. Bedenkt man, daß die Progressionszeit von einem Zustand Grad 3 in CIS etwa ein Jahr beträgt, so wird die Bedeutung der klaren Unterscheidbarkeit gerade in diesem Endentwicklungsstadium, also der eindeutige Unterschied zwischen dem "pre-malignen" Stadium und dem "früh invasiven" Stadium bewußt.

Das in Fig. 10 dargestellte Stadium entspricht einem sehr frühen Stadium CIS, so daß dieser chemische Zustand wesentlich früher und zuverlässiger erkannt werden kann, als nach klassischen histologischen Methoden. So wurde in 19 Fällen durch das erfindungsgemäße Verfahren der Zustand CIS "früh invasiv" eindeutig festgestellt, obwohl andere Methoden 7 Fälle davon noch als "pre-maligne" eingestuft hatten.

Um CIS von invasivem Karzinom zu unterscheiden, muß der Pathologe vollentwickelte atypische Krebszellen außerhalb des Epitheliums finden. Die pre-invasiven und invasiven Krebszellen sind an ihrer Morphologie nicht zu unterscheiden. Ferner kann der Pathologe mit klassischen histologischen oder cytologischen Methoden nicht erkennen, ob sich ein pre-invasiver Zustand in einen invasiven fortentwickeln wird oder sich zum Normalen zurückbilden wird.

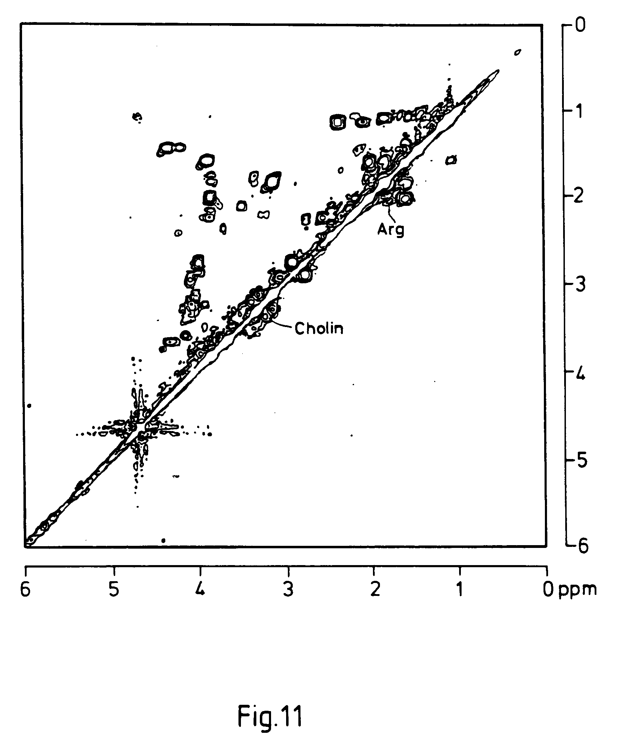

In Fig. 11 ist ein Zustand dargestellt, der einem fortgeschrittenen invasiven Karzinom entspricht, und der durch zusätzliche Cross-peaks von Arginin (Arg, R) und Cholin gekennzeichnet ist.

Die Daten der in den Spektren von Fig. 6 bis 11 jeweils neu auftauchenden Cross-peaks werden jeweils gruppenweise gespeichert und die Daten der Spektren von aktuellen Gewebsproben damit verglichen und entsprechend der zuvor erwähnten Einteilungen den Gruppen "unkritisch", "bedenklich", "pre-maligne", "früh-invasiv" und "fortgeschritten invasiv" zugeordnet. Aus diesen Zuordnungen können dann Diagnosen gestellt und Behandlungsmethoden durchgeführt werden.

Vergleichbare Ergebnisse wurden auch mit anderen Gewebsproben des menschlichen Körpers erzielt, nämlich mit Darm-, Lungen-, Lymphknoten- und Hautgewebe.

In Fig. 4 ist die Impulsfolge einer 2D-COSY-Meßmethode dargestellt, bei der eine $T_2$-Filterung von unerwünschten Signalen durchgeführt wurde. Dies dient dazu, unspezifische Signale auszufiltern und nur auf die charakteristischen Cross-peaks, beispielsweise die von Fig. 6 bis 10 zu messen.

Dabei wird vom Sender T ein 90°-Hochfrequenzimpuls $P_1'$ als Anregung eingestrahlt, und nach einem Zeitpunkt $t_e/2$ werden so oft 180°-Hochfrequenzimpulse $P_2'$ eingestrahlt, daß folgende Bedingung erfüllt ist:

$m \cdot t_e > T_2$-Wert für die nicht erwünschten Signal-komponenten

Danach wird ein dritter 90°-Impuls $P_3$ eingestrahlt und daraufhin der freie Induktionszerfall FID gemessen. Der Decoupler D sorgt bis zum Impuls $P_3$ für eine entsprechende Vorsättigung des Wassersignales.

Um Meßzeit einzusparen, kann z.B. ein selektives zwei- oder eindimensionales COSY-Experiment anstelle der oben beschriebenen Messung durchgeführt werden. Der normalerweise breitbandige Anregungspuls $P_1$, $P_1'$ kann durch einen selektiven Puls mit eingeschränkter Bandbreite (z.B. amplitudenmodulierter Puls mit der Form einer Gauss- oder Sinc-Funktion) ersetzt werden. Dadurch kann die Zahl der notwendigen $t_1$-Punkte stark reduziert werden, um nur die wichtigsten streifenförmigen Bereiche der 2D-Matrix zu erfassen.

Es können somit für bestimmte Zustände charakteristische Crosspeaks, beispielsweise die in Fig. 6 bis 8 beschriebenen Crosspeaks gezielt ausgemessen werden, um zu entscheiden, ob sich das gemessene Gewebe in einer unkritischen Phase befindet oder nicht. Dementsprechend können dann gezielt die in Fig. 9 und 10 dargestellten zusätzlichen Cross-peaks ausgemessen werden, um den Übergangszustand zwischen "pre-malignen" und "früh-invasiven" Zustand zu ermitteln.

Es ist auch möglich, vor der Durchführung von 2D-COSY-Spektren zunächst ein eindimensionales, möglicherweise ebenfalls gefiltertes Spektrum voranzuschalten. Dadurch können solche Linien bestimmt werden, die bereits in einem eindimensionalen Spektrum charakteristisch für Übergangszustände zuordenbar sind. Aufgrund der Vorinformation durch die eindimensionalen Spektren ist es dann möglich, bereits frequenzselektiv (beispielsweise mittels des ersten Impuls $P_1$ oder $P_1'$) die Messung durchzuführen. Dies verkürzt wiederum die Meßzeit.

Es können auch andere 1D- oder 2D-Meßsequenzen beim erfindungsgemäßen Verfahren herangezogen werden, die zur Detektion von ausgewählten Peaks besonders geeignet sind, z.B. I-Modulierung, scalare bzw. dipolare selektive oder nicht-selektive Korrelation.

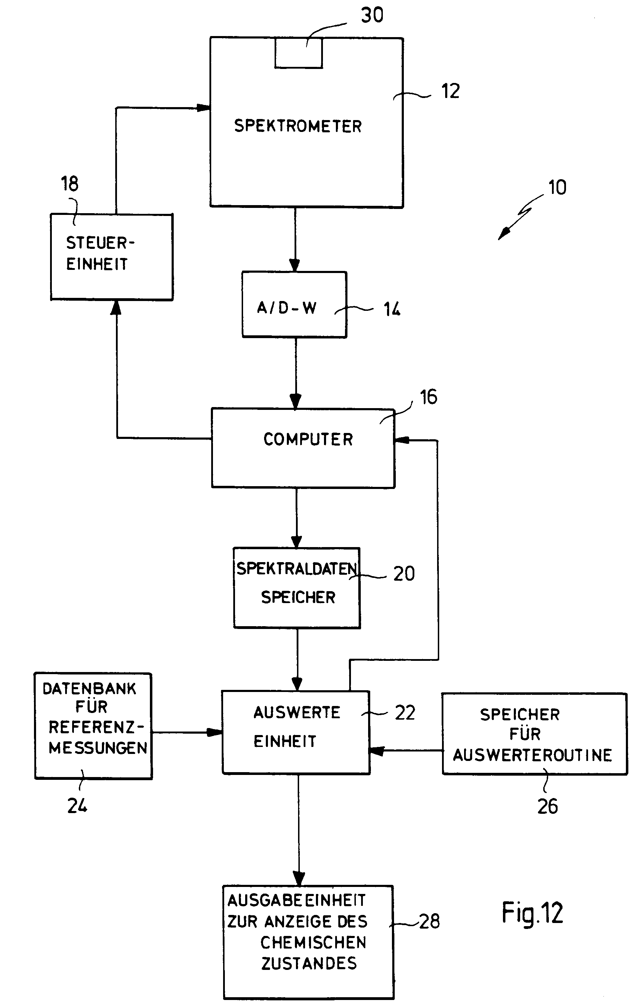

In Fig. 12 ist stark schematisiert eine Vorrichtung 10 zur Durchführung des zuvor beschriebenen Verfahrens dargestellt.

Die Vorrichtung 10 weist ein hochauflösendes, Magnetisches-Resonanz-Spektrometer 12 auf, beispielsweise das zuvor erwähnte Bruker WM-400 Spektrometer.

Das Spektrometer 12 ist mit einem Analog-Digital-Wandler 14 verbunden, der die vom Spektrometer 12 erfaßten analogen Daten digitalisiert einem Rechner 16 zuführt. Der Rechner 16 kann beispielsweise die in der Zeitdomäne erhaltenen Meßwerte über eine Fourier-Transformation in die Frequenzdomäne transformieren.

Der Rechner 16 führt die Daten einem Spektraldatenspeicher 20 zu.

Der Spektraldatenspeicher 20 übermittelt seine Daten einer Auswerteeinheit 22.

Die Auswerteeinheit 22 ist mit einer Datenbank 24 verbunden, in der ein Datensatz an Meßwerten von Referenzmessungen gespeichert ist.

Der Datensatz enthält sämtliche zur Verfügung stehenden Meßwerte eines Gewebes zwischen einem chemisch normalen (gesunden) Zustand und einem chemisch abnormalen Endzustand (stark invasives Karzinom). Die Meßwerte selbst können bereits bearbeitet, dabei insbesondere auf charakteristische Merkmale, wie beispielsweise Intensitätsschwellwerte, reduziert sein.

Die Auswerteeinheit 22 ist mit einem Speicher 26 für einen Auswertealgorithmus verbunden.

Der Speicher 26 kann verschiedene Auswerteroutinen enthalten, die an die jeweilig ausgewählte Art an gewünschter Auswertung angepaßt ist. Über die Auswerteroutine kann beispielsweise der Datensatz in der Datenbank 24 nur nach bestimmten vorgegebenen Werten abgesucht werden, es ist selbstverständlich möglich, auch alle Werte abzusuchen und diese mit allen durch das Spektrometer in einer aktuellen Messung erfaßten Daten zu vergleichen. Dazu ist die Auswerteeinheit 22 mit dem Rechner 16 verbunden. Der Rechner ist außerdem über eine Steuereinheit 18 mit dem Spektrometer 12 verbunden.

Die Auswerteeinheit 22 ist mit einer Ausgabeeinheit 28 zur Anzeige des chemischen Übergangszustandes verbunden.

Die Auswerteeinheit 28 kann das Ergebnis der Auswertung in der jeweils gewünschten Art und Weise darstellen, beispielsweise als Zahlenwert, als Spektrum oder auch als lesbares Ergebnis, wobei beispielsweise die in Fig. 1 dargestellte Unterteilung herangezogen wird.

Dies erleichtert das Vermitteln von Ergebnissen von Routineuntersuchungen dahingehend, daß der aktuelle Zustand des Gewebes lesbar ausgegeben wird, beispielsweise als CIN, Grad 1, "leichte Dysplasie".

Ein Probenkopf 30 des Spektrometers 12 ist im Falle von Gewebsuntersuchungen in vitro so ausgebildet, daß ein die Gewebsprobe aufnehmendes Meßrohrchen eingebracht werden kann.

Es ist selbstverständlich auch möglich, den Probenraum des Spektrometers 12 so auszugestalten, daß in vivo Messungen durchgeführt werden können. Es ist dann beispielsweise möglich, mit Oberflächen-HF-Spulen Körperbereiche auszumessen. Im Fall von Gebärmutteruntersuchungen ist es auch möglich, eine entsprechende Sonde in den Unterleib einzuführen.

## Patentansprüche

1. Verfahren zur Ermittlung von chemischen Zuständen von lebendem, tierischem oder menschlichem Gewebe unter Verwendung von magnetischer Resonanz mit einem homogenen Konstantmagnetfeld, wobei das Gewebe durch eine Magnetische-Resonanz-Messung ausgemessen wird und anschließend die erhaltenen Meßwerte durch Vergleich mit Meßwerten von Referenzmessungen von vergleichbarem Gewebe dahin ausgewertet werden, ob der chemische Zustand des Gewebes einem chemischen Normalzustand oder einem abweichenden abnormalen Endzustand entspricht, dadurch gekennzeichnet, daß die erhaltenen Meßwerte mit einer solchen Reihe an Referenzmessungen verglichen werden, die auch die erfaßbaren, charakteristischen Übergangszustände zwischen dem chemischen Normalzustand und dem abnormalen Endzustand enthalten, und daß aus dem Vergleich der chemische Übergangszustand der gemessenen Gewebeprobe bestimmt wird.

2. Verfahren nach Anspruch 1, dadurch gekennzeichnet, daß das Gewebe mittels einer hochauflösenden, insbesondere einer zweidimensionalen, z.B. einer 2D-COSY-Magnetischen-Resonanz-Messung ausgemessen wird und mit einer Reihe an Meßwerten von chemischen Übergangszuständen von entsprechendem Gewebe verglichen wird.

3. Verfahren nach Anspruch 2, dadurch gekennzeichnet, daß als Kriterium des Vergleichs zwischen aktuellen Meßwerten des Gewebes und der Reihe an Referenzmeßwerten zumindest ein charakteristischer Cross-peak ausgewählt wird, und anschließend ermittelt wird, ob der zumindest eine Cross-peak vorhanden ist oder nicht.

4. Verfahren nach Anspruch 2 oder 3, dadurch gekennzeichnet, daß bei einer hochauflösenden zweidimensionalen Magnetischen-Resonanz-Messung des Gewebes ein oder mehrere Hochfrequenzimpulse, insbesondere der erste, die Transversalmagnetisierung erzeugende Hochfrequenzimpuls $P_1'$, frequenzselektiv auf das Gewebe eingestrahlt wird, wobei die Bandbreite des Hochfrequenzimpulses, zumindest die Resonanzfrequenz eines für einen chemischen Übergangszustand charakteristischen Moleküls umfaßt.

5. Verfahren nach einem der Ansprüche 2 bis 4, dadurch gekennzeichnet, daß bei der Durchführung der Magnetischen-Resonanz-Messung nach Einstrahlen des ersten, die Transversalmagnetisierung erzeugenden Hochfrequenzimpulses $P_1'$, soviel weitere m 180° Hochfrequenzimpulse $P_2'$ vor dem zur Messung des freien Induktionszerfalles FID herangezogenen Impulses $P_3$ eingestrahlt werden, bis die Bedingung:

$m \cdot t_e > T_{2\,n\,i}$ für die nicht erwünschten Signale erfüllt ist, wobei

m die Anzahl der weiteren Hochfrequenzimpulse $P_2'$, $t_e$ die Spinechoevolutionszeit, und $T_{2\,n\,i}$ die transversale Relaxationszeit nach $P_3$ der nicht erwünschten Signale ist.

6. Verfahren nach einem der Ansprüche 1 bis 5, dadurch gekennzeichnet, daß die chemischen Übergangszustände zwischen Normal- und abweichendem Endzustand in die Gruppen unkritische, bedenkliche und pre-maligne Zustände unterteilt werden, die entsprechenden Meßwerte der Referenzmessungen diesen Gruppen an Zuständen zugeordnet werden, so daß beim Vergleich der erhaltenen Meßwerte der gemessenen Gewebsprobe zugleich eine Zuordnung zu einer Gruppe an vorgegebenen chemischen Übergangszuständen erhalten wird.

7. Verfahren nach einem der Ansprüche 1 bis 6, dadurch gekennzeichnet, daß der Reihe an Referenzmeßwerten solche Werte hinzugefügt werden, die chemischen Zwischenzuständen des Gewebes entsprechen, die aus chemischen Veränderungen stammen, die nicht unmittelbar im direkten chemischen Umwandlungsprozeß zwischen Normalzustand und abnormalen Endzustand beteiligt sind, wobei diese Veränderungen jedoch zu dem zum abnormalen chemischen Endzustand führenden Umwandlungsprozeß führen können.

8. Verfahren nach einem der Ansprüche 1 bis 7, dadurch gekennzeichnet, daß eine durch Biopsie erhaltene Gewebeprobe oder eine durch Kultivierung erhaltene Zellmasse in vitro der hochauflösenden Magnetischen-Resonanz-Messung unterzogen wird.

9. Verfahren nach einem der Ansprüche 2 bis 8, dadurch gekennzeichnet, daß auf solche Cross-peaks in einem 2D-COSY-Protonen-Spektrum ausgewertet wird, die den für den Umwandlungsprozeß charakteristischen Mataboliten, insbesondere den für den Aufbau von menschlichen Eiweiß notwendigen Aminosäuren entsprechen.

10. Verfahren nach Anspruch 9, dadurch gekennzeichnet, daß eine Gewebsprobe des Gebärmutterhalses (Cervix uteri) herangezogen wird, und daß bei Vorhandensein von Cross-peaks von zumindest einer der Aminosäuren Isoleucin (Ile), Leucin (Leu), Valin (Val) und/oder Phenylalanin (Phe) in der Gewebsprobe deren chemischer Zustand als "pre-maligne" gewertet wird.

11. Verfahren nach Anspruch 9 oder 10, dadurch gekennzeichnet, daß außerdem auf Cross-peaks ausgewertet wird, die Lactat zuordenbar sind, und daß ein solcher chemischer Zustand als "früh-invasiver" abnormaler Endzustand klassifiziert wird.

12. Verfahren nach einem der Ansprüche 1 bis 11, dadurch gekennzeichnet, daß eine Protonen-Magnet-Resonanz-Messung durchgeführt wird, bei der das $H_2 O$-Signal durch Vorsättigung unterdrückt wird.

13. Vorrichtung zur Ermittlung von chemischen Zuständen von lebendem, tierischem oder menschlichem Gewebe unter Verwendung von magnetischer Resonanz, mit einem Magnetischen-Resonanz-Spektrometer (12) zum Durchführen einer Magnetischen-Resonanz-Messung am Gewebe, mit Mitteln (16) zum Bestimmen von Meßwerten der Magnetischen-Resonanz-Messung am Gewebe, mit Mitteln (24) zum Speichern von Referenzwerten von Messungen an vergleichbarem Gewebe, und mit Mitteln (28) zum Vergleichen der Meßwerte von aktueller Messung und Referenzmessung, dadurch gekennzeichnet, daß die Mittel (24) zum Speichern von Referenzwerten durch eine Datenbank gebildet werden, die eine solche Reihe an Referenzmeßwerten von Referenzmessungen enthält, die auch die erfaßbaren charakteristischen Übergangszustände zwischen dem chemischen Normalzustand und dem chemisch abnormalen Endzustand umfassen, und daß eine Auswerteeinheit (22) vorgesehen ist, die aus dem Vergleich der Meßwerte eine Zuordnung der aktuellen Messung zu einem chemischen Übergangszustand gibt.

14. Vorrichtung nach Anspruch 13, dadurch gekennzeichnet, daß die Auswerteeinheit (22) mit der Datenbank (24) und mit einem Speicher (26) für einen Auswertealgorithmus verbunden ist und die von einem Spektraldatenspeicher (20) zugespeisten aktuellen Meßwerte auswertet und das Ergebnis der Ausgabeeinheit (28) zuführt.

15. Vorrichtung nach Anspruch 14, dadurch gekennzeichnet, daß dem Spektraldatenspeicher (20) ein Rechner (16) vorgeschaltet ist, der über eine Steuereinheit (18) mit dem Spektrometer (12) und auch mit der Auswerteeinheit (22) verbunden ist.

16. Vorrichtung nach einem der Ansprüche 13 bis 15, dadurch gekennzeichnet, daß das Spektrometer (12) einen Probenknopf (30) enthält, um eine in vitro Gewebsprobe auszumessen.

17. Vorrichtung nach einem der Ansprüche 13 bis 15, dadurch gekennzeichnet, daß das Spektrometer eine Probeaufnahme für den tierischen oder menschlichen Körper aufweist, und eine in vivo Messung mit Oberflächen-HF-Spulen ermöglicht.

## Claims

1. Method for determining chemical states of living animal or human tissue using nuclear magnetic resonance with a homogeneous constant magnetic field, the tissue being measured by means of a nuclear magnetic resonance measurement and the measured values obtained then being evaluated by comparison with measured values from reference measurements on comparable tissue to assess whether the chemical state of the tissue corresponds to a chemical normal state or to a deviating abnormal end state, characterized in that the measured values obtained are compared with such a series of reference measurements which also contain the detectable characteristic transition states between the chemical normal state and the abnormal end state and wherein the chemical transition state of the measured tissue sample is determined from the comparison.

2. Method as claimed in claim 1, characterized in that the tissue is measured using a high-resolution, in particular a two-dimensional, for example a 2D-COSY, nuclear magnetic resonance measurement and compared with a series of measured values for chemical transition states of corresponding tissue.

3. Method as claimed in claim 2, characterized in that at least one characteristic cross-peak is selected as criterion for the comparison between actual measured values for the tissue and the series of reference measured values and it is then determined whether or not the at least one crosspeak is present.

4. Method as claimed in claim 2 or 3, characterized in that the tissue is irradiated frequency-selectively with one or more high-frequency pulses, in particular the first high-frequency pulse $P_1'$ generating the transverse magnetisation, during a high-resolution two-dimensional nuclear magnetic resonance measurement of the tissues, the band width of the high-frequency pulse comprising at least the resonance frequency of a molecule characteristic for a chemical transition state.

5. Method as claimed in any one of claims 2 to 4, characterized in that, when the nuclear magnetic resonance measurement is carried out, after radiation of the first high-frequency pulse $P_1'$ generating the transverse magnetisation, further m 180° high-frequency pulses $P_2'$ are radiated, before the pulse $P_3$ used for measurement of the free induction decay FID, in the number required until the condition:
$m \cdot t_e > T_{2ni}$ is met for the undesired signals,
m being the number of further high-frequency pulses $P_2'$, $t_e$ the spin echo evolution time and $T_{2ni}$ the transverse relaxation time after $P_3$ of the undesired signals.

6. Method as claimed in any one of claims 1 to 5, characterized in that the chemical transition states between normal state and deviating end state are subdivided into the groups non-critical, dubious and pre-malignant states, and the corresponding measured values for the reference measurements are assigned to these groups of states so that on comparison of the measured values obtained for the measured tissue sample an allocation to a group of pre-defined chemical transition states is obtained at the same time.

7. Method as claimed in any one of claims 1 to 6, characterized in that those particular values are added to the series of reference measured values which correspond to chemical intermediate states of the tissue which originate from chemical changes which are not directly involved in the direct chemical transformation process between the normal state and the abnormal end state, but, it is possible that these changes lead to the transformation process which in turn leads to the abnormal chemical end state.

8. Method as claimed in any one of claims 1 to 7, characterized in that a tissue sample obtained by biopsy or a cell mass obtained by culture is subjected to the high-resolution nuclear magnetic resonance measurement in vitro.

9. Method as claimed in any one of claims 2 to 8, characterized in that the evaluation is carried out on those cross-peaks in a 2D-COSY proton spectrum which corresponds to the metabolites characteristic for the transformation process and in particular to the amino acids needed for building up human protein.

10. Method as claimed in claim 9, characterized in that a tissue sample from the neck of the uterus (cervix uteri) is used, and if cross-peaks of at least one of the amino acids isoleucine (Ile), leucine (Leu), valine (Val) and/or phenylalanine (Phe) are present in the tissue sample the chemical state thereof is assessed as "pre-malignant".

11. Method as claimed in claim 9 or 10, characterized in that evaluation is also carried out for cross-peaks which are assignable to lactate and wherein such a chemical state is classified as "early invasive" abnormal end state.

12. Method as claimed in any one of claims 1 to 11, characterized in that a proton nuclear magnetic resonance measurement is carried out in which the $H_2O$ signal is suppressed by pre-saturation.

13. Apparatus for determining chemical states of living animal or human tissue using nuclear magnetic resonance, comprising a nuclear magnetic resonance spectrometer (12) for carrying out a nuclear magnetic resonance measurement on the tissue, means (16) for determining measured values for the nuclear magnetic resonance measurement on the tissue, means (24) for storing reference values for measurements on comparable tissue and means (28) for comparing the measured values for actual measurement and reference measurement, characterized in that the means (24) for storing reference values consist of a database which contains such a series of reference values for reference measurements which also comprise the detectable characteristic transition states between the chemical normal state and the chemically abnormal end state and wherein a computation unit (22) is provided which, from the comparison of the measured values, makes an assignment of the actual measurement to a chemical transition state.

14. Apparatus as claimed in claim 13, characterized in that the computation unit (22) is connected to the database (24) and to a memory (26) for a computation algorithm and computes the actual measured values supplied from a spectral data memory (20) and supplies the result to the output unit (28).

15. Apparatus as claimed in claim 14, characterized in that a computer (16), which is connected via a control unit (18) to the spectrometer (12) and also to the computation unit (22), is connected in series with and in front of the spectral data memory (20).

16. Apparatus as claimed in any one of claims 13 to 15, characterized in that the spectrometer (12) contains a sample head (30) in order to measure an in vitro tissue sample.

17. Apparatus as claimed in any one of claims 13 to 15, characterized in that the spectrometer has a sample receiver for the animal or human body and facilitates an in vivo measurement with surface HF coils.

**Revendications**

1. Procédé de détection des états chimiques de tissus humains ou animaux vivants par résonance magnétique au moyen d'un champ magnétique constant homogène, le tissu étant mesuré selon un procédé de mesure par résonance magnétique, et les valeurs de mesure ainsi obtenues étant ensuite évaluées par comparaison avec des valeurs de mesure de référence de tissus comparables, de façon à déterminer si l'état chimique du tissu correspond à un état chimique normal ou à un état final anormal qui dévie de la norme, caractérisé en ce que les valeurs de mesure obtenues sont comparées à une série de mesures de référence qui comprend également les états de transition caractéristiques détectables entre l'état chimique normal et l'état final anormal, et en ce que l'état chimique de transition de l'échantillon de tissu mesuré est déterminé à partir de la comparaison.

2. Procédé selon la revendication 1, caractérisé en ce que le tissu est mesuré selon un procédé de mesure par résonance magnétique à haute résolution, en particulier à deux dimensions, par exemple un procédé 2D-COSY, et est comparé à une série de valeurs de mesure d'états de transition chimiques de tissus correspondants.

3. Procédé selon la revendication 2, caractérisé en ce qu'est sélectionné, comme critère de comparaison entre les valeurs de mesure actuelles du tissu et la série de valeurs de mesure de référence, au moins un pic caractéristique et qu'est déterminé, ensuite, si le pic, au nombre minimum d'un, est présent ou non.

4. Procédé selon la revendication 2 ou 3, caractérisé en ce que, dans le cas d'une mesure du tissu par résonance magnétique à deux dimensions et à haute résolution, une ou plusieurs impulsions haute fréquence, en particulier la première impulsion haute fréquence $P_1'$ générant la magnétisation transversale, est appliquée sur le tissu de façon sélective en fréquence, la largeur de bande de l'impulsion haute fréquence comprenant au moins la fréquence de résonance d'une molécule caractéristique d'un état de transition chimique.

5. Procédé selon l'une des revendications 2 à 4, caractérisé en ce que, lorsqu'est réalisée la mesure par résonance magnétique, après l'application de la première impulsion haute fréquence $P_1'$ générant la magnétisation transversale, on applique autant d'impulsions haute fréquence supplémentaires m 180° $P_2'$, avant l'impulsion $P_3$ prise pour mesurer la désagrégation d'induction libre FID, jusqu'à ce que la condition :

$m \cdot t_e > T_{2n1}$ de signaux indésirables soit remplie, sachant que

m est le nombre d'impulsions haute fréquence supplémentaires $P_2'$,

$t_e$ est le temps d'évolution de l'écho du spin et

$T_{2n1}$ est le temps de relaxation transversale après l'impulsion $P_3$ des signaux indésirables.

6. Procédé selon l'une des revendications 1 à 5, caractérisé en ce que les états chimiques de transition entre l'état normal et l'état final qui dévie de la norme sont répartis en groupes d'états non critiques, critiques et pré-malins, les valeurs de mesure de référence correspondantes étant associées à ces groupes d'états, de telle sorte que, lors d'une comparaison avec les valeurs de mesure obtenues pour l'échantillon de tissu mesuré, on réalise en même temps une attribution dans un groupe d'états chimiques de transition prédéterminés.

7. Procédé selon l'une des revendicatins 1 à 6, caractérisé en ce que sont ajoutées à la série de valeurs de mesure de référence, les valeurs correspondant à des états de transition du tissu, qui proviennent de modifications chimiques ne participant pas directement au processus de transformation chimique direct entre l'état normal et l'état final anormal, ces modifications pouvant cependant conduire au processus de transformation conduisant à l'état final chimique anormal.

8. Procédé selon l'une des revendications 1 à 7, caractérisé en ce qu'un échantillon de tissus obtenu par biopsie ou une masse cellulaire obtenue par culture est soumis à un procédé de mesure par résonance magnétique de haute résolution.

9. Procédé selon l'une des revendications 2 à 8, caractérisé en ce que l'évaluation est réalisée, dans un spectre à protons 2D-COSY, sur des pics qui correspondent aux métabolites caractéristiques du processus de transformation, en particulier aux amino-acides qui sont nécessaires pour la formation d'albumine humaine.

10. Procédé selon la revendication 9, caractérisé en ce qu'un échantillon de tissus du col de l'utérus (cervix uteri) est prélevé et qu'en cas de présence de pics d'au moins l'un des amino-acides choisi parmi l'isoleucine (Ile), la leucine (Leu), la valine (Val) et la phénylalanine (Phe) dans l'échantillon de tissus, son état chimique est considéré comme "pré-malin".

11. Procédé selon la revendication 9 ou 10, caractérisé en ce que l'évaluation est réalisée, en outre, sur des pics susceptibles d'être associés au lactate, et en ce qu'un tel état chimique est classifié comme état final anormal "pré-invasif".

12. Procédé selon l'une des revendications 1 à 11, caractérisé en ce qu'est réalisée une prise de mesures par résonance magnétique de protons dans laquelle le signal $H_2O$ est supprimé par présaturation.

13. Dispositif de détection des états chimiques de tissus humains ou animaux vivants par résonance magnétique, au moyen de la résonance magnétique, comportant un spectromètre (12) à résonance magnétique permettant de réaliser une mesure de résonance magnétique sur le tissu, des moyens (16) permettant d'obtenir des valeurs de mesure de résonance magnétique sur les tissus, des moyens (24) de mise en mémoire de valeurs de référence de mesures sur un tissu comparable, et des moyens (28) permettant de comparer les valeurs de mesure de la mesure actuelle et de la mesure de référence, caractérisé en ce que les moyens (24) de mise en mémoire de valeurs de référence sont constitués par une banque de données contenant une série de valeurs de référence de mesures de référence telle qu'elle comprenne également les états de transition caractéristiques détectables entre l'état chimique normal et l'état chimique final anormal, et en ce qu'est prévue une unité d'évaluation (22) permettant de faire, à partir de la comparaison des valeurs de mesure, une imputation de la mesure actuelle à un état chimique de transition.

14. Dispositif selon la revendication 13, caractérisé en ce que l'unité d'évaluation (22) est reliée à la banque de données (24) et à une mémoire (26) pour un algorithme d'évaluation et fait une évaluation des valeurs de mesure actuelles mémorisées par une mémoire de données de spectre (20) et fait parvenir le résultat à l'unité de sortie (28).

15. Dispositif selon la revendication 14, caractérisé en ce qu'un calculateur (16) est monté en amont de la mémoire de données de spectre (20), calculateur qui est relié, par l'intermédiaire d'une unité de commande (18), au spectromètre (12) et également à l'unité d'évaluation (22).

16. Dispositif selon l'une des revendications 13 à 15, caractérisé en ce que le spectromètre (12) contient un bouton échantillonneur (30) afin de pouvoir mesurer un échantillon de tissu in vitro.

17. Dispositif selon l'une des revendications 13 à 15, caractérisé en ce que le spectromètre contient un système de prélèvement d'échantillons pour le corps animal ou humain qui permet de réaliser une mesure in vivo avec des bobines HF de surface.

Fig.1

Fig. 2

Fig. 3

Fig. 4

Fig. 5

Fig.6

Fig.7

Fig.8

Fig.9

Fig. 10

Fig.11

Fig.12